# EUROPEAN PATENT APPLICATION

(11) **EP 4 739 024 A1**
(43) Date of publication of application: **06.05.2026**
(21) Application number: 24210894.2
(22) Date of filing: 05.11.2024
(51) Int. Cl.: H10B 43/35, H10D 30/69, H10B 43/27, H10D 30/67

(54) **TRANSISTOR STRUCTURE, VERTICAL NAND FLASH MEMORY, AND METHOD**

(71) Applicant: Imec VZW, 3001 Leuven (BE)
(72) Inventor: VERRECK, Devin, 3212 Pellenberg (BE); RACHIDI, Sana, 3000 Leuven (BE); ROSMEULEN, Maarten, 9000 Gent (BE)
(74) Representative: Roth, Sebastian

(57) **Abstract**

A transistor structure for a vertical NAND flash memory device is provided. The transistor structure comprises a semiconductor channel layer, a first auxiliary layer and a second auxiliary layer arranged at two opposite sides of the semiconductor channel layer along a first axis, and each of the first auxiliary layer and the second auxiliary layer comprises a first material having a first relative permittivity, the first relative permittivity being larger than 1 and lower than 3.9. The transistor structure further comprises: a first dielectric layer arranged above the semiconductor channel layer, the first auxiliary layer and the first auxiliary layer along a second axis that is perpendicular to the first axis; a charge storage layer arranged on the first dielectric layer; a second dielectric layer arranged on the charge storage layer; and a gate layer arranged on the second dielectric layer.

## Description

### TECHNICAL FIELD

The present disclosure provides a transistor structure for a vertical NAND flash memory, and a method for processing the transistor structure. A vertical NAND flash memory comprising one or more of the transistor structures is also provided.

### BACKGROUND

A flash memory is a type of non-volatile memory that can be electrically programmed and erased. A NAND flash is a special type of flash memory, in which the individual memory cells are connected in series in the form of a NAND gate. A NAND flash with a three-dimensional (3D) architecture, i.e. a NAND flash with memory cells that are arranged vertically, is generally referred to as 3D NAND or vertical NAND.

NAND flash memory is able to store information in a non-volatile way in the form of charge carriers (electrons or holes), either in a charge trap layer or in a floating gate that is part of a flash cell transistor. The concentration of stored charge carriers corresponds to the bits of information stored in the memory, and can be read by a resulting threshold voltage shift of the flash cell transistor. Quantum tunneling is utilized to change the concentration of the charge carriers, thereby writing or erasing information to/from the memory.

The dimensions of the flash cells of the vertical NAND flash memories have been scaled down over successive technology generations to increase bit densities. The production technology has transitioned from planar devices to vertical, 3D structures, in which the memory string consists of a cylindrical memory hole along which the flash cells are stacked, also called gate-all-around (GAA) strings. These strings can be fabricated by first depositing a stack of alternating layers, followed by etching a memory hole and then filling the memory hole with the memory and channel layers.

Such 3D structures allow increasing the bit density by adding more cells to the strings, rather than scaling the cell dimensions. However, the etching process becomes more challenging as the aspect ratio of the memory holes increases, thereby ultimately limiting the number of cells on a string.

To further increase the bit density, efforts have focused on scaling down the vertical cell pitch, which comprises the flash cell gate length and the inter-gate spacing. This, however, increases the interference between cells, and degrades the gate control over the carrier injection.

Alternatively, a 3D trench cell architecture has been developed for the vertical NAND flash memory. Instead of cylindrical holes, as in the conventional GAA structure, the memory strings in the 3D trench cell architecture are fabricated in elongated trenches, wherein each trench accommodates multiple strings in which the channels are separated with an insulating oxide material. This allows packing the strings very closely together, thereby increasing the bit density.

Transitioning to a 3D trench cell with scaled vertical pitch enables large bit densities, but also significantly degrades the memory operation of the cells. The flash cells in the trenches are flat, and therefore do not benefit from the so-called "curvature effect" of GAA cells. In a cylindrical GAA cell, the tunnel oxide has a smaller radius than the blocking oxide, which ensures a larger electric field in the tunnel oxide than in the blocking oxide for a given gate voltage. This benefits the injection of the charge carriers through the tunnel oxide relative to their escape through the blocking oxide, and therefore improves the memory operation. Further, since in the 3D trench cell architecture the memory stack is flat, the electric field is more evenly distributed over the tunnel and blocking oxides.

The memory operation the 3D trench cell architecture is further degraded as the vertical cell pitch is scaled, similar to GAA structures. Combined with the flat cell geometry, this can lead to poor overall memory performance.

### SUMMARY

It is thus an objective of this disclosure to provide a 3D trench NAND flash memory structure with improved performance, and an improved method for processing the memory structure. In particular, the above-mentioned disadvantages should be avoided.

The objective and other advantages are achieved by the embodiments provided in the independent claims. Advantageous implementations are further defined in the dependent claims.

Hereinafter in this disclosure, the terms "vertical NAND flash memory" and "3D trench NAND flash memory structure" are used interchangeably. That is, the disclosure is concerned with a vertical NAND flash memory with the trench structure, and not to a GAA structure.

According to a first aspect, the present disclosure relates to a transistor structure for a vertical NAND flash memory device. The transistor structure comprises a semiconductor channel layer, and a first auxiliary layer and a second auxiliary layer arranged at two opposite sides of the semiconductor channel layer along a first axis, wherein each of the first auxiliary layer and the second auxiliary layer comprises a first material having a first relative permittivity, the first relative permittivity being larger than 1 and lower than 3.9. The transistor structure further comprises a first dielectric layer arranged above the semiconductor channel layer, the first auxiliary layer and the second auxiliary layer, along a second axis that is perpendicular to the first axis. Further, the transistor structure comprises a charge storage layer arranged on the first dielectric layer, a second dielectric layer arranged on the charge storage layer, and a gate layer arranged on the second dielectric layer.

The first auxiliary layer and the second auxiliary layer at both sides of the semiconductor channel layer may generally act as so-called "pockets" with a low relative permittivity, as will be explained in detail later on. The semiconductor channel may be referred to as a fin, which extends between the two auxiliary layers along the second axis. Said fin being sandwiched along the first axis by the two auxiliary layers.

Each of the first dielectric material layer and the second dielectric material layer can be formed from a dielectric material, such as silicon oxide or silicon nitride.

In this disclosure, the terms "semiconductor channel layer" "channel layer" and "channel" may be used interchangeably.

The transistor structure according to the first aspect provides the advantage of inducing charge polarization at the interface between each pocket and the first dielectric layer, which locally increases the electric field around the interface between the channel and the first dielectric layer, particularly, at the corners of the channel. The corners of the semiconductor channel layer refer to two opposite sides of the channel (along the first axis) that are in direct contact with the first dielectric layer above the channel layer and the respective first or second auxiliary layer to the side of the channel layer.

Further, when the transistor structure is used to form a vertical NAND flash memory, the aforementioned enhanced electric field at the corners of the channel results in an enhanced carrier injection during programming and erase of the vertical NAND flash memory.

The transistor structure may be a flash cell transistor or floating gate transistor. Thus, the first dielectric layer may be or may act as a tunnel oxide layer, the charge storage layer may be or may act as a floating gate, the second dielectric layer may be or may act as a blocking oxide layer, and the gate layer may be or may act as a control gate. Accordingly, these terms are used interchangeably in this disclosure. Thus, when a high voltage is applied to the control gate, charge carriers (electrons or holes) can tunnel from the channel to the tunnel oxide layer along the second axis, and remain there even when the control gate voltage is removed.

In an implementation form of the first aspect, the first auxiliary layer partially extends into the first dielectric layer along the second axis. Additionally or alternatively, the second auxiliary layer partially extends into the first dielectric layer along the second axis.

This is beneficial for enhancing the electric field at the interface between the first auxiliary layer (or first pocket) and the first dielectric layer, and/or at the interface between the second auxiliary layer (or second pocket) and the first dielectric layer.

In an implementation form of the first aspect, the first material is or comprises air. In this case, the first auxiliary layer and the second auxiliary layer may act as air-gaps at both sides of the semiconductor channel layer.

Alternatively, the first material comprises a porous material.

Both, the porous material forming the pockets and the air in the case of the air-gaps have the relative permittivity being between 1 and 3.9.

In an implementation form of the first aspect, the first dielectric layer comprises a second material having a second relative permittivity. The second relative permittivity is larger than the first relative permittivity.

Thus, the first auxiliary layer and the second auxiliary layer at both sides of the semiconductor channel have the (first) relative permittivity that is low compared to the (second) relative permittivity of the tunnel oxide (or first dielectric layer), i.e., the first material has a low (first) permittivity.

This increases the electric field at the interface between the first auxiliary layer and the first dielectric layer, and at the interface between the second auxiliary layer and the first dielectric layer.

Such an enhanced electric field is a result of a charge polarization that is induced at the interface between the pocket and the tunnel oxide due to the difference in their respective relative permittivity. The larger electric field in the tunnel oxide results in a higher tunneling probability for the charge carriers, therefore enhancing the injection of carriers from the channel into the tunnel oxide.

In an implementation form of the first aspect, a cross section of the semiconductor channel layer in a region below the first dielectric layer comprises a rectangular shape or a trapezoidal shape or a triangular shape.

This provides the advantage of further enhancing the electric field at the corners of the channel and in the vicinity of the interface between the channel and the tunnel oxide. Thereby, the injection of charge carriers from the channel into the tunnel oxide is further enhanced.

In an implementation form of the first aspect, the transistor structure further comprises a first spacer layer arranged between the first auxiliary layer and the semiconductor channel layer along the first axis.

Additionally or alternatively, the transistor structure further comprises a second spacer layer arranged between the semiconductor channel layer and the second auxiliary layer along the first axis.

This allows an easy integration in the fabrication process for conventional architectures, since in conventional vertical NAND flash memories, inter-channel spacer layers are provided to reduce crosstalk between the channels.

In an implementation form of the first aspect, the first spacer layer and/or the second spacer layer comprise a third material.

The third material has a third relative permittivity, and the third relative permittivity is larger than the first relative permittivity and smaller than the second relative permittivity.

In an implementation form of the first aspect, each of the first spacer layer and the second spacer layer may be made of silicon dioxide (SiO₂).

SiO₂ inter-channel spacers are usually employed in conventional vertical NAND flash memory architectures.

In an implementation form of the first aspect, the transistor structure further comprises a source structure and a drain structure. The source structure is arranged in region next to the first auxiliary layer, and the drain structure is arranged in a region next to the second auxiliary layer.

According to a second aspect, the present disclosure relates to a vertical NAND flash memory device comprising one or more transistor structures according to the first aspect.

That is, the transistor structure according to the first aspect can be, or may act as, a memory cell for the vertical NAND flash memory device.

By introducing the pockets or air-gaps next to the string of channels with a reduced permittivity relative to that of the tunnel oxide, charge polarization is induced at the interface between each pocket or air gap and the tunnel oxide that locally increases the electric field around the corners of the channels, thereby resulting in an enhanced charge carrier injection during programming and erase of the memory.

According to a third aspect, the present disclosure relates to a method for fabricating a transistor structure for a vertical NAND flash memory. The method comprises: forming a semiconductor channel layer; forming a first auxiliary layer and a second auxiliary layer at two opposite sides of the semiconductor channel layer along a first axis, wherein each of the first auxiliary layer and the second auxiliary layer comprises a first material with a first relative permittivity, the first relative permittivity being larger than 1 and lower than 3.9; forming a first dielectric layer above the semiconductor channel layer, the first auxiliary layer and the second auxiliary layer, along a second axis perpendicular to the first axis; forming a charge storage layer on the first dielectric layer; forming a second dielectric layer on the charge storage; and forming a gate layer on the second dielectric layer.

Optionally, before forming the semiconductor channel layer, the method may comprise a step of providing substrate. Then, the semiconductor channel layer may be formed above the substrate, and both the first and second auxiliary layers may be formed above the substrate and at the two opposite sides of the semiconductor channel layer along the first axis.

The method may further comprise a step of forming a source structure in a region next to the first auxiliary layer along the first axis. Additionally or alternatively, the method may further comprise a step of forming a drain structure in a region next to the second auxiliary layer along the first axis.

The semiconductor channel layer, and the first and second dielectric layers can be formed by using a suitable deposition technique, for example chemical vapor deposition (CVD), plasma enhanced chemical vapor deposition (PECVD), reduced pressure chemical vapor deposition (RPCVD), atomic layer deposition (ALD), or other deposition techniques.

The first auxiliary layer and the second auxiliary layer comprising air, i.e., the air-gaps, can be formed by deposition, subsequent thermal decomposition and outdiffusion of a polymer to create the air gaps. Prior processing said polymer, the method may include deposition of an oxide liner that has to be sufficiently thin to allow for the polymer outdiffusion. This is structurally sound, since when the method is also used to fabricate the vertical NAND flash memory according to the second aspect, the liner may be supported on two sides by the channel layers over a full length of a string of transistor structures according to the first aspect (i.e., a string of memory cells).

On another hand, when the first auxiliary layer and the second auxiliary layer comprise the porous material with low relative permittivity, the pockets can be formed with a method that does not rely on the polymer deposition and later outdiffusion as in the case for forming air-gaps. Thereby, the first auxiliary layer and the second auxiliary layer comprising the porous material can be formed in relative simple manner.

### BRIEF DESCRIPTION OF THE DRAWINGS

The above described aspects and implementations are explained in the following description of embodiments with respect to the enclosed figures:
- Fig. 1: shows a schematic diagram of a transistor structure according to an embodiment;
- Fig. 2: shows a schematic diagram of a transistor structure according to an embodiment;
- Fig. 3: shows a schematic diagram of a transistor structure according to an embodiment;
- Fig. 4: shows a schematic diagram of a transistor structure according to an embodiment;
- Fig. 5: shows a schematic diagram of a transistor structure according to an embodiment;
- Fig. 6a)-b): depict each an electric field in a transistor structure according to an embodiment;
- Fig. 7a)-d): depict each an electric field in a transistor structure according to an embodiment;
- Fig. 8: shows examples for the first material according to this disclosure;
- Fig. 9: shows steps of a method for fabricating a transistor structure according to an embodiment;
- Fig. 10a)-h): show exemplary method steps for fabricating a vertical NAND flash memory according to an embodiment; and
- Fig. na)-f): show exemplary method steps for fabricating a vertical NAND flash memory according to an embodiment.

Same elements shown in the figures are labeled with the same reference sign, and may be implemented likewise. The size of elements in the figures are not drawn to scale and may be different compared to a real life implementation in order to highlight details of the embodiments.

### DETAILED DESCRIPTION OF THE PREFERRED EMBODIMENTS

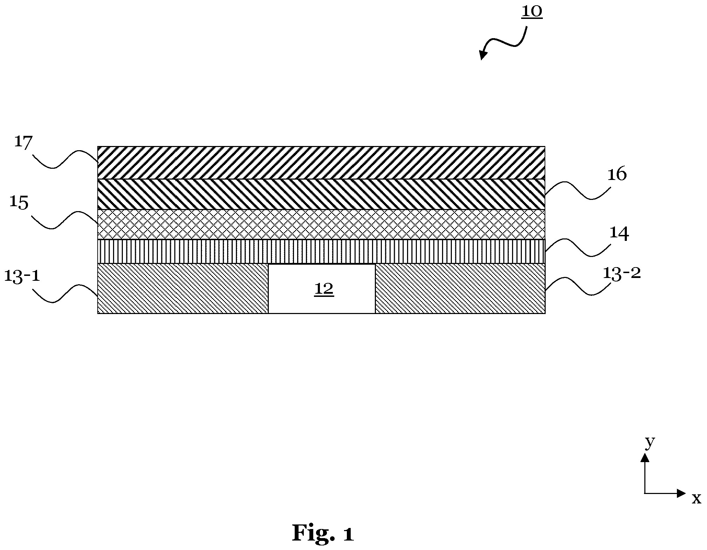

Fig. 1 shows a schematic diagram of a transistor structure 10 according to an embodiment. In particular, Fig. 1 shows a cross-sectional view of the transistor structure 10 along an x-y plane in the schematic coordinate system shown in Fig. 1.

The transistor structure 10 comprises a semiconductor channel layer 12, a first auxiliary layer 13-1 and a second auxiliary layer 13-2 that are arranged at two opposite sides of the semiconductor channel layer 12 along a first axis, for example the x-axis in the schematic coordinate system shown in Fig. 1.

Each of the first auxiliary layer 13-1 and the second auxiliary layer 13-2 comprises a first material. The first material has a first relative permittivity ε_{r,1}, that is larger than 1 and lower than 3.9. That is, 1<ε_{r,1}<3.9.

The relative permittivity is also known as dielectric constant, and materials having a small dielectric constant relative to SiO₂ are referred to as low-k materials. Thus, in this disclosure, the first material is also referred to as first low-k material and, accordingly, each of the first auxiliary layer 13-1 and the second auxiliary layer 13-2 may comprise a first low-k material.

The first material may be, or may comprise, air, which has the first relative permittivity ε_{r,1≈}1.

Alternatively, the first material may be, or may comprise, a porous material having the first relative permittivity between 1 and 3.9, as mentioned above. In other words, the first material may be, or may comprise, a low-k porous material.

When the first material is air, each of the first auxiliary layer 13-1 and the second auxiliary layer 13-2 may be referred to as an air-gap, and when the first material is the low-k porous material, each of the first auxiliary layer 13-1 and the second auxiliary layer 13-2 may be referred to as a pocket.

As shown schematically in Fig. 1, the first auxiliary layer 13-1, the semiconductor channel layer 12 and the second auxiliary layer 13-2 have a vertical dimension along the second axis that may be equal to each other. For example, the vertical dimension may be a thickness or a height of the respective layer and, thus, the first auxiliary layer 13-1, the semiconductor channel layer 12 and the second auxiliary layer 13-2 may have the same thickness, i.e., the three layers may be aligned.

In the embodiment according to Fig. 1, the first auxiliary layer 13-1 and the semiconductor channel layer 12 are arranged next to each other along the first axis, and may be directly in contact with each other. Additionally, the second auxiliary layer 13-2 and the semiconductor channel layer 12 are arranged next to each other along the first axis, and may be directly in contact with each other.

The first auxiliary layer 13-1 and the semiconductor channel layer 12 may not be directly in contact with each other along the first axis, and/or the second auxiliary layer 13-2 and the semiconductor channel layer 12 may not be directly in contact with each other along the first axis, as will be explained later on.

Referring to Fig. 1 the transistor structure 10 further comprises a first dielectric layer 14 arranged above the semiconductor channel layer 12, the first auxiliary layer 13-1 and the first auxiliary layer 13-1, along a second axis that is perpendicular to the first axis, for example the y-axis indicated in the schematic coordinate system shown in Fig. 1.

Further, the transistor structure 10 comprises a charge storage layer 15 arranged on the first dielectric layer 14, a second dielectric layer 16 arranged on the charge storage layer 15, and a gate layer 17 arranged on the second dielectric layer 16.

That is, the first dielectric layer 14, the charge storage layer 15, the second dielectric layer 16 and the gate layer 17 are vertically arranged (along the y-axis) above the first auxiliary layer 13-1, the semiconductor channel layer 12 and the first auxiliary layer 13-2. Further, the first auxiliary layer 13-1, the semiconductor channel layer 12 and the first auxiliary layer 13-2 are horizontally arranged (along the x-axis) with respect to each other.

As explained above, the transistor structure 10 may be a flash cell transistor or floating gate transistor. Thus, the fist dielectric layer 14 may be or may act as a tunnel oxide layer, the charge storage layer 15 may be or may act as a floating gate, the second dielectric layer 16 may be or may act as a blocking oxide layer, and the gate layer 17 may be or may act as a control gate.

The first dielectric layer 14 comprises, or is made of, a second material that has a second relative permittivity ε_{r,2}. The second relative permittivity ε_{r,2} is larger than the first relative permittivity ε_{r,1}, ε_{r,1}<ε_{r,2}.

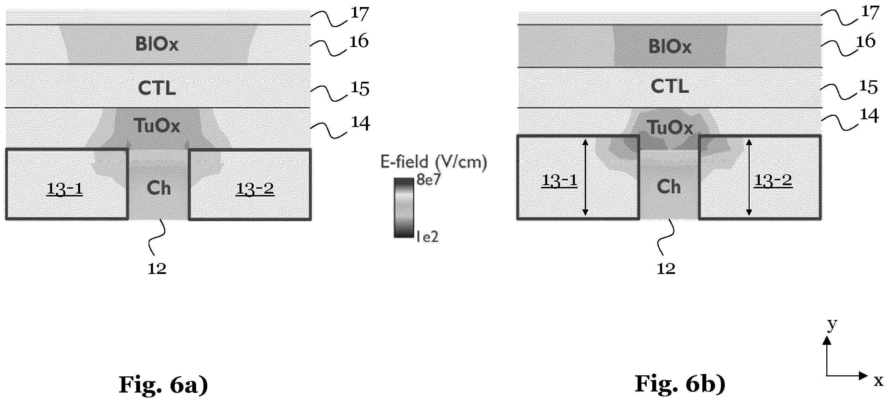

By introducing a pocket or an air-gap at both sides of the semiconductor channel layer 12 with a reduced permittivity relative to that of the first dielectric layer 14 (or tunnel oxide), charge polarization is induced at an interface between each pocket/air-gap and the first dielectric layer. Said charge polarization locally increases an electric field around the corners of the semiconductor channel layer 12, wherein the corners of the semiconductor channel layer 12 refer to the two opposite sides of the semiconductor channel layer 12 along the first axis that are in contact with the first dielectric layer 14 and that are in the vicinity of the two pockets/air-gaps. Fig. 6a) depicts simulations results for the electric field in the transistor structure 10 according to Fig. 1, which shows the electric field enhancement at the corners of the semiconductor channel layer 12.

Thereby, when the transistor structure 10 is used as a memory cell in a vertical NAND flash memory device, the enhanced electric field results in an enhanced carrier injection during programming and erase of the memory device.

Moreover, the beneficial impact of the pockets or air gaps 13-1, 13-2 is stronger for small values value of the first relative permittivity ε_{r,1}. That is, a larger difference between the third relative permittivity ε_{r,3} and the first permittivity ε_{r,1}, i.e., a larger difference between the relative permittivity of the first dielectric layer 14 and the relative permittivity of the first or second auxiliary layers 13-1, 13-2, results in an further enhanced induced charge polarization for a given gate voltage and, hence, a larger electric field enhancement at the channel corners.

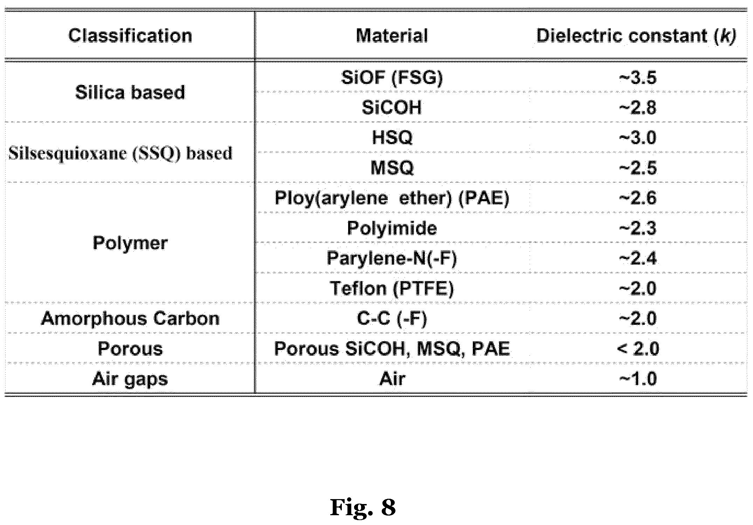

For example and not as a limitation, Fig. 8 shows exemplary first materials that can be comprised in the first auxiliary layer 13-1 and/or the second auxiliary layer 13-2 and a value of their corresponding first relative permittivity. In the figure, the term dielectric constant is used as being equivalent to the relative permittivity.

Furthermore, introducing the pockets or air-gaps at both sides of the semiconductor channel layer 12, provides the additional advantage of reducing crosstalk with neighboring channels when one or more transistor structures 10 are used as memory cells in the vertical NAND flash memory device.

In the embodiment according to Fig. 1, a cross section of the semiconductor channel layer 12 in a region below the first dielectric layer 14 comprises a rectangular, or substantially rectangular, shape.

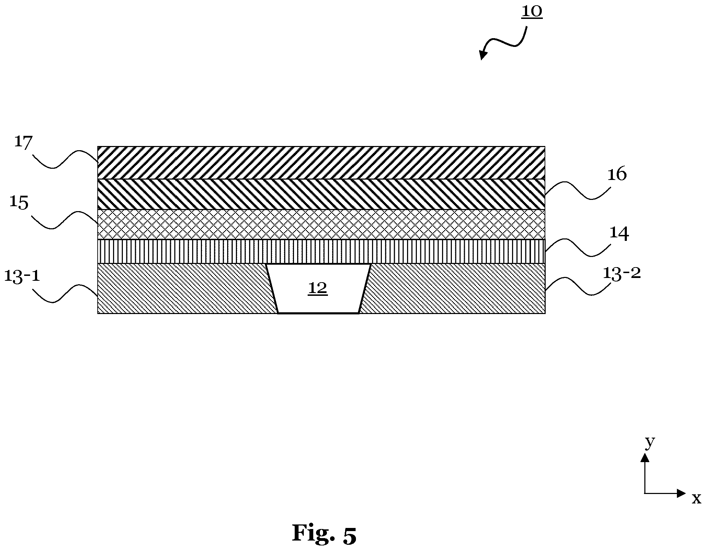

Alternatively, the cross section of the semiconductor channel layer 12 in the region below the first dielectric layer 14 may comprise any other shape, for example a trapezoidal, or substantially trapezoidal, shape, as shown in the embodiment according to Fig. 5, or a triangular shape.

By forming a non-rectangular-shaped interface between the semiconductor channel layer 12 and the first dielectric layer 14, the electric field at said interface can be further enhanced.

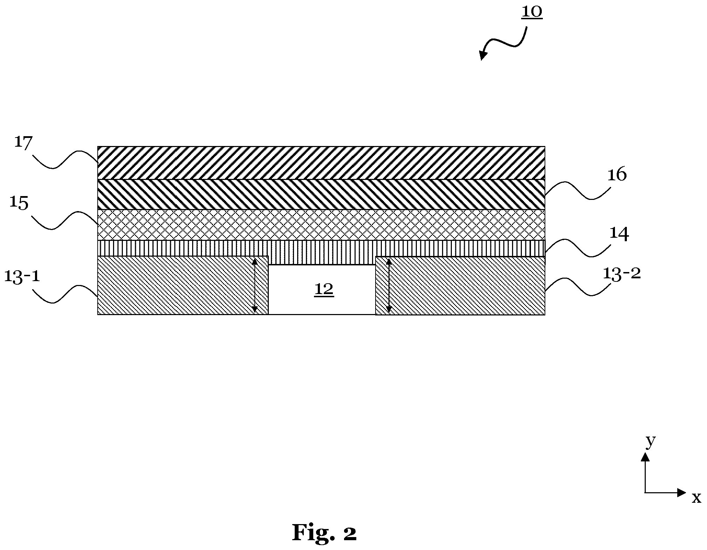

Fig. 2 shows a schematic diagram of a transistor structure 10 according to an embodiment, which builds on the embodiment shown in Fig. 1. In particular, Fig. 2 shows a cross-sectional view of the transistor structure 10 along the x-y plane. Hereinafter, only the differences between Fig. 2 and Fig. 1 are explained.

In the transistor structure 10 according to Fig. 2, the first auxiliary layer 13-1 partially extends into the first dielectric layer 14 along the second axis, for example the y-axis.

Additionally or alternatively, the second auxiliary layer 13-2 partially extends into the first dielectric layer 14 along the second axis, for example the y-axis.

This is beneficial, since such an extension may further enhance the electric field around the corners of the semiconductor channel layer 12, as shown in Fig. 6b).

The pockets or air-gaps may not necessarily extend along a full thickness of the first dielectric layer 14 to enhance the electric field.

Optionally, the cross section of the semiconductor channel layer 12 in the region below the first dielectric layer 14 comprises a rectangular shape or a trapezoidal shape (not shown) or a triangular shape (not shown), thereby further enhancing the electric field at the interface between the semiconductor channel layer 12 and the first dielectric layer 14.

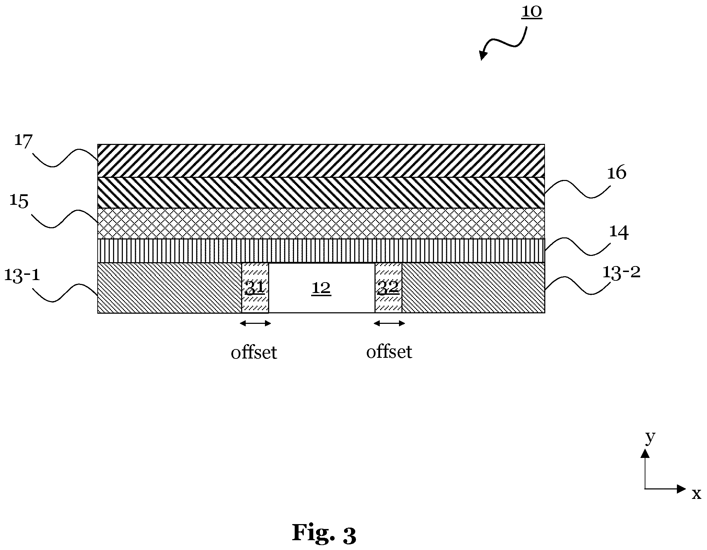

Fig. 3 shows a schematic diagram of a transistor structure 10 according to an embodiment, which builds on the embodiment shown in Fig. 1. In particular, Fig. 3 shows a cross-sectional view of the transistor structure 10 along the x-y plane. Hereinafter, only the differences between Fig. 3 and Fig. 1 are explained.

The transistor structure 10 according to Fig. 3 further comprises a first spacer layer 31 arranged between the first auxiliary layer 13-1 and the semiconductor channel layer 12 along the first axis.

Additionally or alternatively, the transistor structure 10 further comprises a second spacer layer 32 arranged between the semiconductor channel layer 12 and the second auxiliary layer 13-2 along the first axis.

Each of the first spacer layer 31 and the second spacer layer 32 comprises, or is formed by, a third material. The third material has a third relative permittivity ε_{r,3} that is larger than the first relative permittivity ε_{r,1} and smaller than the second relative permittivity ε_{r,2}, that is, ε_{r,1}<ε_{r,3}<ε_{r,2}.

For example, the third material comprises or is SiO₂.

The enhancement of the electric field at the corners of the semiconductor channel layer 12 maybe smaller compared to the embodiment according to Fig. 1 due to the presence of the first spacer layer 31 and the second spacer layer 32. Notably, since the pockets or air gaps 13-1,13-2 have the lowest relative permittivity ε_{r,1} compared to that of the first dielectric layer 14 and the first spacer layer 31 and/or the second spacer layer 32, the effect provided by the pockets/air gaps 13-1, 13-2 can still be obtained.

Moreover, since conventional vertical NAND flash memory devices typically comprise SiO₂ spacers between channels lines to reduce crosstalk between neighboring channels, the embodiment according to Fig. 3 provides a similar effect than the embodiment according to Figs. 1 and 2 with the advantage of being compatible with existing architectures.

Each of the first spacer layer 31 and the second spacer layer 32 has a lateral dimension along the first axis, for example a width or offset. Thus, in this embodiment, the offset of the first spacer layer 31 and/or the second spacer layer 32 may be tailored in order to achieve the desired electric field enhancement, as depicted in Figs. na)-d).

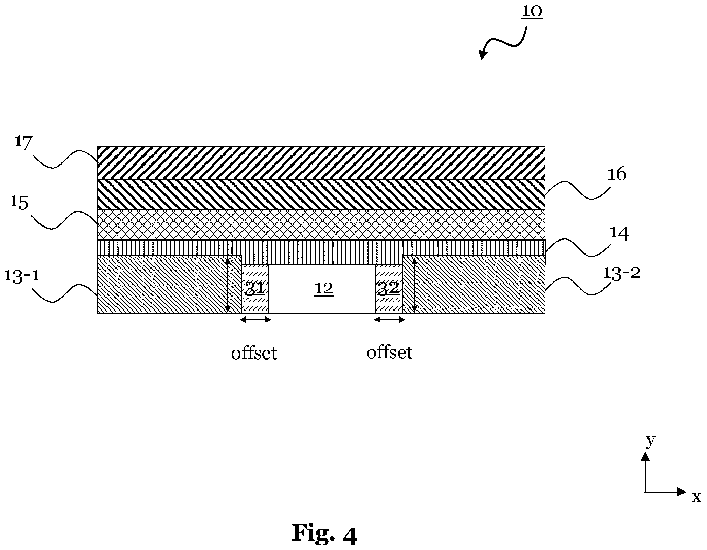

Fig. 4 shows a schematic diagram of a transistor structure 10 according to an embodiment, which builds on the embodiment shown in Fig. 3. In particular, Fig. 4 shows a cross-sectional view of the transistor structure 10 along the x-y plane. Hereinafter, only the differences between Fig. 4 and Fig. 3 are explained.

In the embodiment according to Fig. 4, the first auxiliary layer 13-1 partially extends into the first dielectric layer 14 along the second axis. Additionally or alternatively, the second auxiliary layer 13-2 partially extends into the first dielectric layer 14 along the second axis.

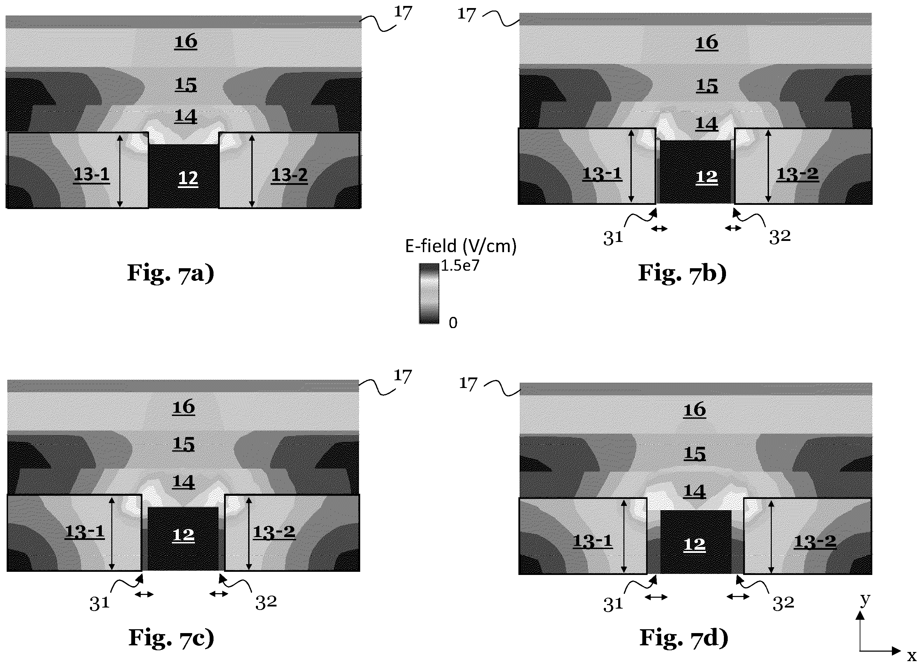

Thus, in this embodiment, the thickness (or height) of the pockets/air-gaps 13-1, 13-2 may be designed to counteract the effect of the first and second spacer layers 31, 32 so that the desired enhancement of the electric field at the corners of the semiconductor channel layer 12 can be achieved, as depicted in Figs. 7a) to 7d), where the interplay between the extension (thickness or height) of the pockets/air- gaps 13-1, 13-2 and the width (offset) of the first and second spacer layers 31,32 is shown.

Optionally, the cross section of the semiconductor channel layer 12 in the region below the first dielectric layer 14 may comprises a rectangular shape or a trapezoidal shape (not shown) or a triangular shape (not shown).

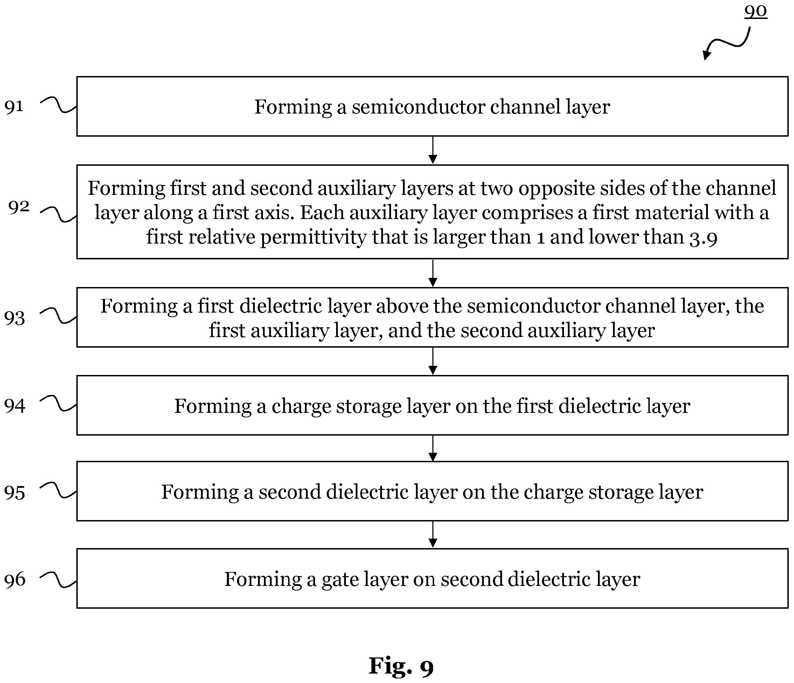

Fig. 9 shows a method 90 for fabricating the transistor structure 10, according to an embodiment.

The method 90 comprises a step 91 of forming a semiconductor channel layer 12.

The method 90 further comprises a step 92 of forming a first auxiliary layer 13-1 and a second auxiliary layer 13-2 at two opposite sides of the semiconductor channel layer 12 along a first axis. Each of the first auxiliary layer 13-1 and the second auxiliary layer 13-2 comprises a first material with a first relative permittivity, the first relative permittivity being larger than 1 and lower than 3.9.

Then, in a step 93, the method 90 comprises forming a first dielectric layer 14 above the semiconductor channel layer 12, the first auxiliary layer 13-1 and the second auxiliary layer 13-2, along a second axis that is perpendicular to the first axis.

In a step 94, the method 90 comprises forming a charge storage layer 15 on the first dielectric layer 14.

Further, the method 90 comprises a step 95 of forming a second dielectric layer 16 on the charge storage.

Then, in a step 96, the method 90 comprises forming a gate layer 17 on the second dielectric layer 16.

In an embodiment, before the step 93, the method 90 may comprise an optional step 92-2 of forming a first spacer layer 31 between the first auxiliary layer 13-1 and the semiconductor channel layer 12 along the first axis. Additionally or alternatively, the step 92-2 may comprise forming a second spacer layer 32 between the semiconductor channel layer 12 and the second auxiliary layer 13-2 along the first axis.

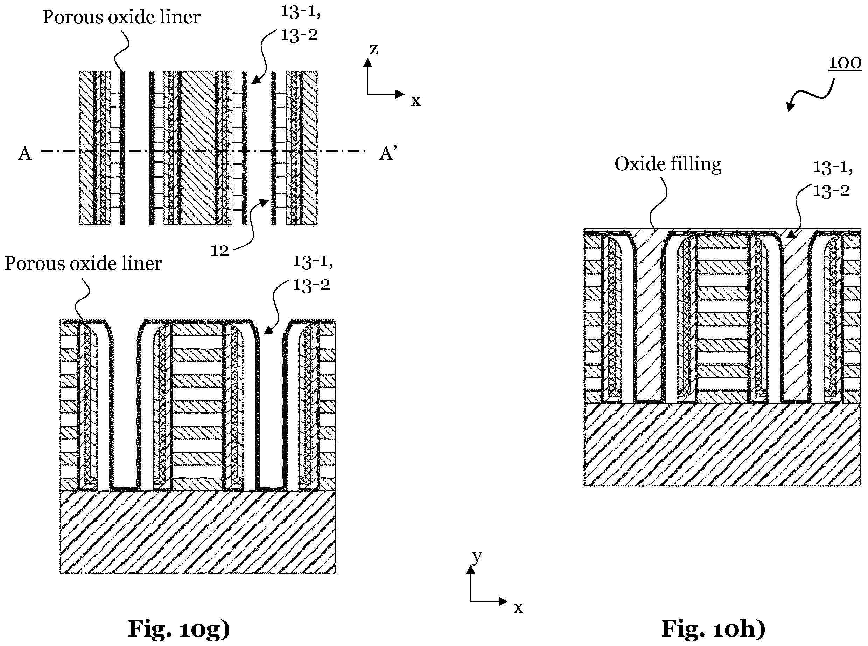

Fig. 10h) shows a schematic diagram of a cross section of a vertical NAND flash memory device 100 according to an embodiment. The vertical NAND flash memory device 100 comprises one or more of the transistor structures 10 according to any one of Figs. 1 to 5.

The vertical NAND flash memory device 100 may be a 3D NAND flash memory.

In the vertical NAND flash memory device 100 according to Fig. 10h), the first material comprised in the first auxiliary layer 13-1 and the second auxiliary layer 13-2 is air. In other words, the vertical NAND flash memory device 100 according to Fig. 10h) comprises a plurality of air gaps 13-1, 13-2.

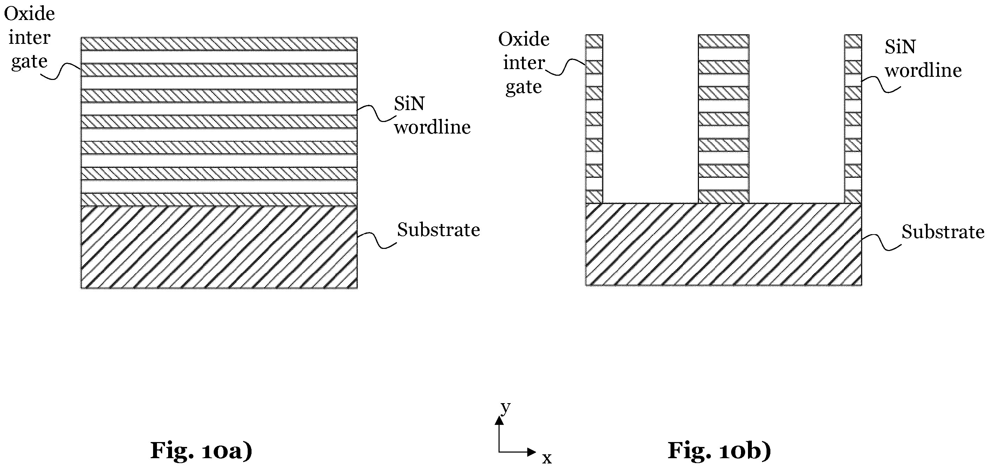

Figs. 10a)-h) schematically depict an example for a fabrication method of the vertical NAND flash memory device 100 according to an embodiment.

In a first step of the method, shown in Fig. 10a), a substrate may be provided and a first layer stack may be formed on the substrate.

The first layer stack may comprise one or more oxide inter-gate spacing layers alternating with one or more silicon mononitride (SiN) layers. The SiN layers may form word lines of the vertical NAND flash memory device 100.

The substrate may be a silicon substrate, for example a silicon wafer.

The first layer stack may be formed by alternately depositing the oxide inter-gate spacing layers and the SiN layers with a suitable deposition technique, for example CVD, PECVD, RPCVD, ALD or other.

In a second step of the method, shown in Fig. 10b), one or more trenches may be formed in the first layer stack, wherein each trench may completely penetrate the one or more oxide inter-gate spacing layers and the one or more SiN layers.

Each trench may be formed with a suitable directional etching technique.

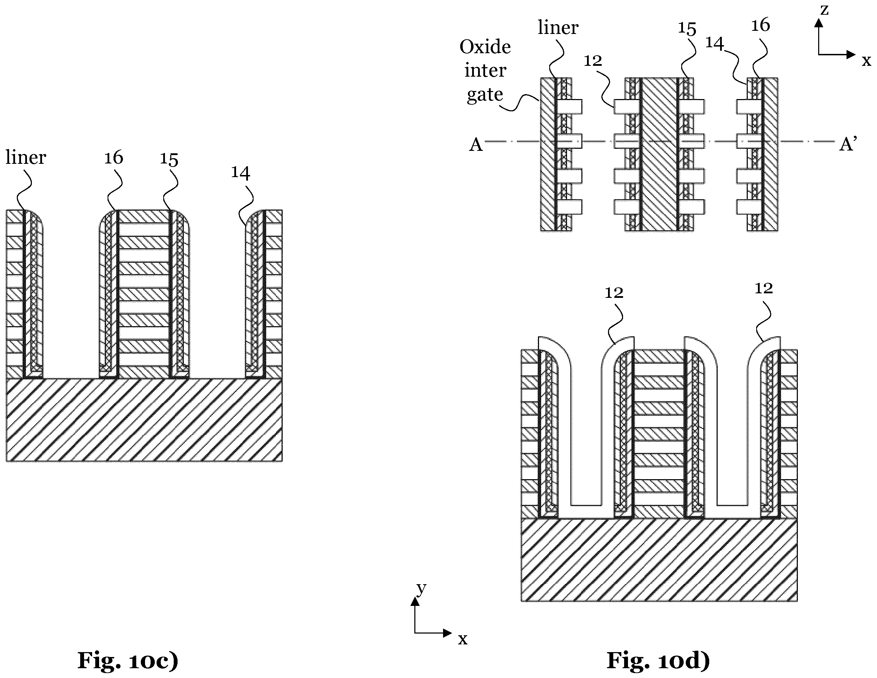

In a third step of the method, shown in Fig. 10c), a second layer stack may be formed in each trench. The second layer stack may comprise: a thin layer of a high-k liner material, the first dielectric layer 14 formed on the thin layer of the high-k liner material, the charge storage layer 15 formed on the first dielectric layer 14, and the second dielectric layer 16 arranged on the charge storage layer 15.

The high-k liner material comprises, or may be, a material having high relative permittivity compared to the relative permittivity of SiO₂.

The second layer stack may be formed by alternately depositing the thin layer of the high-k liner material, the first dielectric layer 14, the charge storage layer 15, and the second dielectric layer 16, each with a suitable deposition technique, for example CVD, PECVD, RPCVD, ALD or other.

The second layer stack may also be referred to as a high-k ONO structure.

Then, the second layer stack in each trench may be further patterned with a suitable lithography step, using a suitable lithography mask and a suitable isotropic or anisotropic wet or dry etching technique, leaving the substrate exposed.

In a fourth step of the method, shown in Fig. 10d), the semiconductor channel layer 12 may be formed on side walls of the recess formed upon patterning the second layer stack, and on the substrate.

The semiconductor channel layer 12 maybe formed by depositing a semiconductor material with a suitable deposition technique, for example CVD, PECVD, RPCVD, ALD or other.

Further, the deposited semiconductor material can be patterned with a suitable lithography step, using a suitable lithography mask and a suitable isotropic or anisotropic wet or dry etching technique.

The upper part of Fig. 10d) shows a top view of the structure formed in this step, and the lower part is a cross section along the A-A' line.

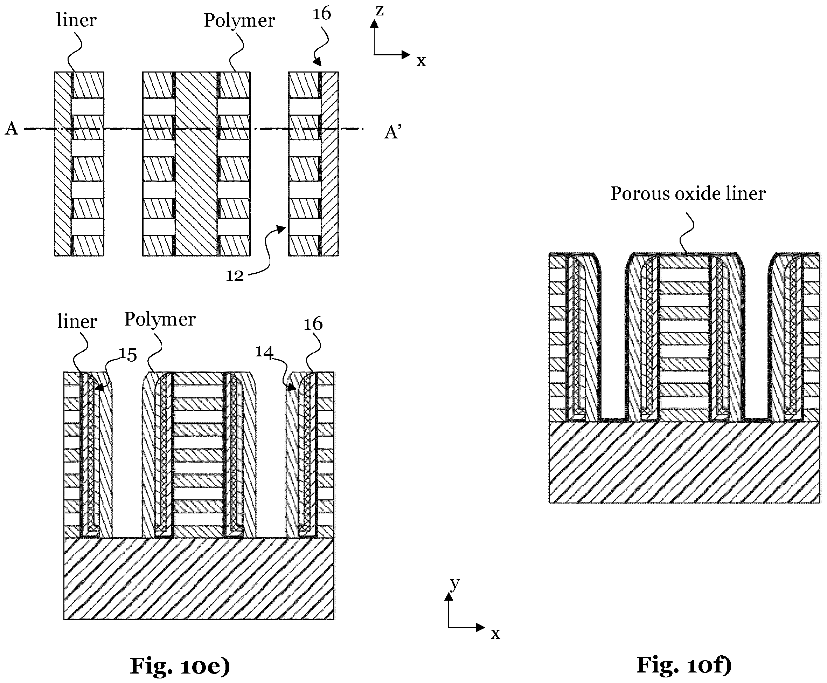

In a fifth step of the method, shown in Fig. 10e), a polymer layer may be formed on the semiconductor channel layer 12.

The polymer layer 12 may be formed by depositing a polymer material with a suitable deposition technique, for example CVD, PECVD, ALD or other, on side walls of the recess formed in the previous steps and on the substrate.

The polymer material can be further patterned with a suitable lithography step, using a suitable lithography mask and a suitable isotropic or anisotropic wet or dry etching technique, leaving the substrate exposed.

The upper part of Fig. 10e) shows a top view of the structure formed in this step, and the lower part is a cross section along the A-A' line.

In a sixth step of the method, shown in Fig. 10f), an oxide liner layer maybe formed on the polymer layer and on the substrate.

The oxide liner layer may be formed by depositing a porous oxide material with a suitable deposition technique, for example CVD, PECVD, ALD or other, on side walls of the recess formed in the previous step and on the substrate.

In a seventh step of the method, shown in Fig. 10g), the first auxiliary layer 13-1 and the second auxiliary layer 13-2 particularly comprising air, i.e., the air pockets, may be formed by using e.g. a suitable thermal treatment and further decomposition of the polymer layer.

The thermal treatment and the decomposition of the polymer layer may not affect the oxide liner layer, as shown in Fig. 10g).

The upper part of Fig. 10g) shows a top view of the structure formed in this step, and the lower part is a cross section along the A-A' line.

In an eight step of the method, shown in Fig. 10h), an oxide filling material may be deposited to fill the one or more trenches formed in the previous steps, thereby forming the vertical NAND flash memory device 100.

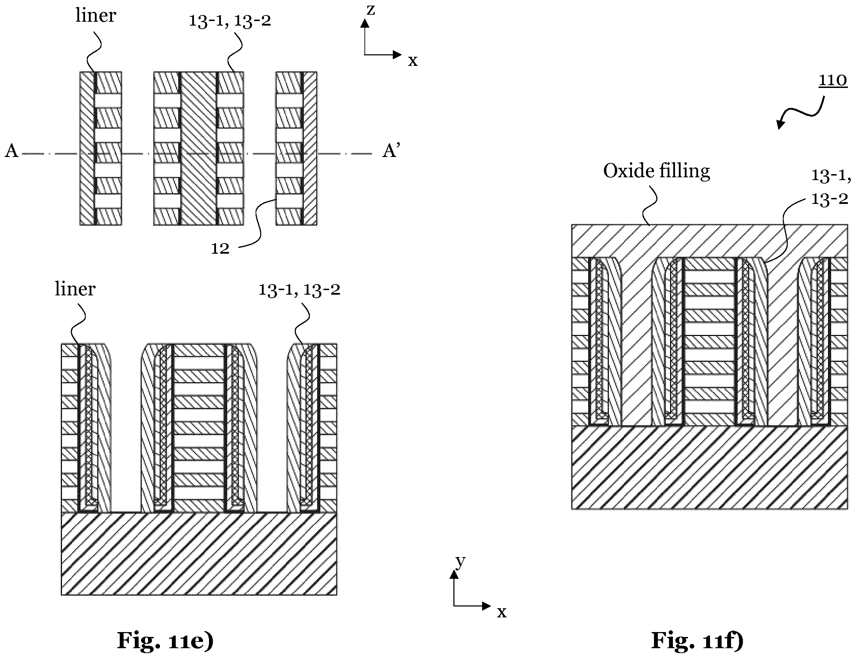

Fig. 11f) shows a schematic diagram of a cross section of a vertical NAND flash memory device iio according to an embodiment. The vertical NAND flash memory device 110 comprises one or more of the transistor structures 10 according to any one of Figs. 1 to 5, and can be a 3D NAND flash memory.

In the vertical NAND flash memory device 110 according to Fig. 11f), the first material comprised in the first auxiliary layer 13-1 and the second auxiliary layer 13-2 is the porous material with the first permittivity being larger than one and smaller than 3.9, 1<ε_{r,1}<3.9. In other words, the vertical NAND flash memory device 110 according to Fig. nf) comprises a plurality of pockets 13-1, 13-2 comprising the first low-k material.

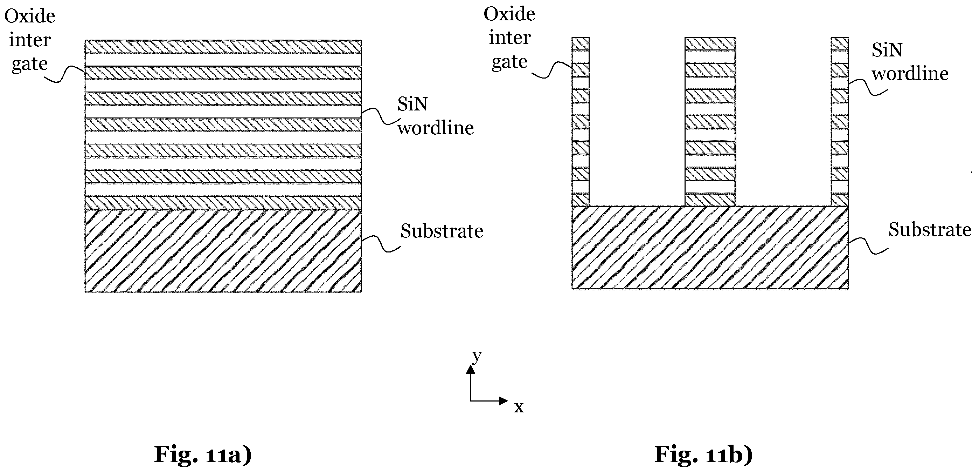

Figs. 11a)-f) schematically depict an example for a fabrication method of the vertical NAND flash memory device iio according to an embodiment.

In a first step, shown in Fig. 11a) the method may comprise forming the substrate and the first layer stack. The first step according to Fig. 11a) is the same as the first step of the method according to Fig. 10a) explained above, and the details are not repeated again.

In a second step, shown in Fig, 11b), the method may comprise forming the one or more trenches in the first layer stack. The second step according to Fig. 11b) is the same as the second step of the method according to Fig. 10b) explained above, and the details are not repeated again.

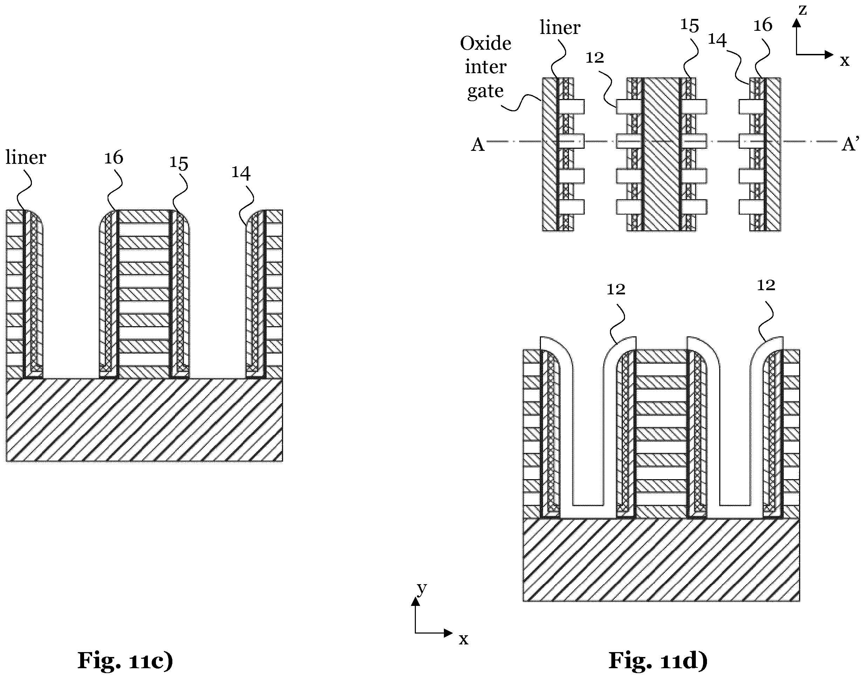

In a third step, shown in Fig. 11c), the method may comprise forming and subsequently patterning the second layer stack. The third step according to Fig. 11c) is the same as the third step of the method according to Fig. 10c) explained above, and the details are not repeated again.

In a fourth step, shown in Fig. 11d), the method may comprise forming the semiconductor channel layer 12 on side walls of the recess formed upon patterning the second layer stack, and on the substrate. The fourth step according to Fig. 11d) is the same as the second step of the method according to Fig. 10d) explained above, and the details are not repeated again.

In a fifth step of the method, shown in Fig. 11e), the first auxiliary layer 13-1 and the second auxiliary layer 13-2 may be formed on the semiconductor channel layer 12.

The first auxiliary layer 13-1 and the second auxiliary layer 13-2 may be formed by depositing the first material having the first relative permittivity, i.e., the first low-k material, with a suitable deposition technique, for example CVD, PECVD, ALD or Other, on side walls of the recess formed in the previous step, and on the substrate. As explained above, the first material in this embodiment is different from air.

Further, the first material can be patterned with a suitable lithography step, using a suitable lithography mask and a suitable isotropic or anisotropic wet or dry etching technique, leaving the substrate exposed.

Alternatively, the first auxiliary layer 13-1 and the second auxiliary layer 13-2 may be formed by performing area selective deposition (ASD) of the first material (i.e., the low-k material) on the tunnel oxide and between the channel layers 12, wherein the process is selective to the channel 12 (that is, the material of the channel 12, i.e., there is no deposition on the channel 12).

Thereby, the pockets 13-1, 13- 2 may be formed at both sides of the channel 12.

The upper part of Fig. 11e) shows a top view of the structure formed in this step, and the lower part is a cross section along the A-A' line.

In a sixth step of the method, shown in Fig. 11f), the oxide filling material may be deposited to fill the one or more trenches formed in the previous steps, thereby forming the vertical NAND flash memory device 110.

By incorporating the pockets or air-gaps 13-1,13-2 at both sides of each of the channels 12 and with the low permittivity relative to that of the tunnel oxide 14, the vertical NAND flash memory device 100, 110 according to the embodiments of Figs. 10h) and 11f) provide the advantage of inducing charge polarization at the interface between the pockets/air-gaps 13-1, 13- 2 and the tunnel oxide 14 that locally increases the electric field around the corners of the channel 12, thereby resulting in an enhanced carrier injection during programming and erase of the memory 100, 110. This is reflected in a significantly improved onset and a slope of an incremental step pulse programming (ISPP) curve of the vertical NAND flash memory device 100, 110.

## Claims

1. A transistor structure (10) for a vertical NAND flash memory device, wherein the transistor structure (10) comprises:
a semiconductor channel layer (12);
a first auxiliary layer (13-1) and a second auxiliary layer (13-2) arranged on two opposite sides of the semiconductor channel layer (12) along a first axis, wherein each of the first auxiliary layer (13-1) and the second auxiliary layer (13-2) comprises a first material having a first relative permittivity, the first relative permittivity being larger than 1 and lower than 3.9;
a first dielectric layer (14) arranged above the semiconductor channel layer (12), the first auxiliary layer (13-1) and the second auxiliary layer (13-2), along a second axis perpendicular to the first axis;
a charge storage layer (15) arranged on the first dielectric layer (14);
a second dielectric layer (16) arranged on the charge storage layer (15); and
a gate layer (17) arranged on the second dielectric layer (16).

2. The transistor structure (10) according to claim 1, wherein:
the first auxiliary layer (13-1) partially extends into the first dielectric layer (14) along the second axis; and/or
the second auxiliary layer (13-2) partially extends into the first dielectric layer (14) along the second axis.

3. The transistor structure (10) according to claim 1 or 2, wherein:
the first material is or comprises air; or
the first material comprises a porous material.

4. The transistor structure (10) according to any one of the preceding claims, wherein:
the first dielectric layer (14) comprises a second material having a second relative permittivity, the second relative permittivity being larger than the first relative permittivity.

5. The transistor structure (10) according to any one of the preceding claims, wherein:
a cross section of the semiconductor channel layer (12) in a region below the first dielectric layer (14) comprises a rectangular shape or a trapezoidal shape or a triangular shape.

6. The transistor structure (10) according to any one of the preceding claims, further comprising:
a first spacer layer (31) arranged between the first auxiliary layer (13-1) and the semiconductor channel layer (12) along the first axis; and/or
a second spacer layer (32) arranged between the semiconductor channel layer (12) and the second auxiliary layer (13-2) along the first axis.

7. The transistor structure (10) according to claim 6, wherein:
the first spacer layer (31) and/or the second spacer layer (32) comprise a third material, the third material having a third relative permittivity, and the third relative permittivity being larger than the first relative permittivity and smaller than the second relative permittivity.

8. The transistor structure (10) according to claim 7, wherein:
the third material comprises SiO2.

9. A vertical NAND flash memory (100, 110) comprising one or more transistor structures (10) according to any one of the preceding claims.

10. A method (90) for fabricating a transistor structure (10) for a vertical NAND flash memory, the method comprising:
forming (91) a semiconductor channel layer (12);
forming (92) a first auxiliary layer (13-1) and a second auxiliary layer (13-2) at two opposite sides of the semiconductor channel layer (12) along a first axis, wherein each of the first auxiliary layer (13-1) and the second auxiliary layer (13-2) comprises a first material with a first relative permittivity, the first relative permittivity being larger than 1 and lower than 3.9;
forming (93) a first dielectric layer (14) above the semiconductor channel layer (12), the first auxiliary layer (13-1) and the second auxiliary layer (13-2), along a second axis perpendicular to the first axis;
forming (94) a charge storage layer (15) on the first dielectric layer (14);
forming (95) a second dielectric layer (16) on the charge storage; and
forming (96) a gate layer (17) on the second dielectric layer (16).
